# EUROPEAN PATENT APPLICATION

(11) **EP 4 797 725 A1**
(43) Date of publication of application: **26.08.2026**
(21) Application number: 25204864.0
(22) Date of filing: 26.09.2025
(51) Int. Cl.: H04R 1/10, F16B 2/12, F16B 5/12

(54) **HEADSET**

(30) Priority: 25.02.2025 CN 202520302334 U
(71) Applicant: Shenzhen Asmax Infinite Technology Co., Ltd., Shenzhen, Guangdong 518057 (CN)
(72) Inventor: Luo, Cheng, Shenzhen, Guangdong, 518057 (CN); Wang, Peng, Shenzhen, Guangdong, 518057 (CN); Zhang, Xiaohong, Shenzhen, Guangdong, 518057 (CN)
(74) Representative: Plavsa, Olga

(57) **Abstract**

A headset is provided, which includes a host, a base, sliding plates and a base spring. One side of the outer wall of the host has host inverted buckles for assembly and disassembly with the base. One side of the outer wall of the base has left and right base buckles for buckling with the host inverted buckles, and the other side of the outer wall of the base has buckle buttons for driving the left and right base buckles. The sliding plates are used to connect the buckle buttons with the left and right base buckles. The base spring is used to drive the sliding plates, the buckle buttons and the left and right base buckles to reset. In this headset, by pressing the buckle buttons and stretching the spring, the left and right base buckles disengage from the host, ensuring the safe separation between the host and the base.

## Description

### TECHNICAL FIELD

The present disclosure relates to the technical field of headsets, in particular to a headset.

### BACKGROUND

With the continuous progress of science and technology, headsets, as portable audio devices, are more and more widely used in daily life and work. There are various types of headsets, including wired headsets and wireless headsets. Headsets are deeply loved by consumers for their excellent sound quality, convenient user experience and good sound isolation effect. Especially nowadays with the prevalence of mobile devices, headsets have not only become an important tool for personal music enjoyment, but are also widely used in telephone calls, audio and video entertainment and in catering to the needs of game enthusiasts. However, as users' requirements for the comfort and functionality of headsets continue to increase, it is particularly important to develop a connection method that can ensure the stable connection of the headset and facilitate disassembly.

**In** the prior art, many headsets are mechanically connected through conventional plug and jack designs, and this structure usually relies on the physical contact between the plug and the jack to transmit signals and supply power. This design is simple and easy to implement, but has many limitations. For example, some headsets are connected by buckles or card slots. Although these mechanical structures enhance the stability between headsets and devices to a certain extent, in actual use, they often encounter problems such as cumbersome disassembly, easy wear, or an unstable interface. In addition, traditional connection methods struggle to strike a balance between convenience and reliability, which easily leads to the loosening of the interface after long-term use, thus affecting the sound quality and service life of the headsets.

In the prior art, when disassembling the headset, users usually face the problem that it is difficult to disassemble or the disassembly is unstable due to the complexity of the connection structures. This not only increases the users' burden but also may damage the connecting components during frequent plugging and unplugging, thus affecting the overall performance and stability of the headset. Therefore, how to design a more convenient and reliable connection method has become an important challenge in the current development of headsets.

### SUMMARY

**In** order to make up for the above shortcomings, the present disclosure provides a headset, aiming to improve the situation where users often have difficulty disassembling the headset or the disassembly is unstable due to the complexity of the connection structures in the prior - art headset disassembly. This not only increases the user's burden but also may damage the connecting components during frequent plugging and unplugging, thus affecting the overall performance and stability of the headset.

To achieve the above purpose, the present disclosure provides the following technical scheme. A headset is configured to be installed on a helmet for intercom use, including:
a host, which has host magnets at its two inner ends, and one side of its outer wall has host inverted buckles for assembling and disassembling with the base;
a base, which has base magnets at its two inner ends, one side of its outer wall has left and right base buckles to be buckled with the host inverted buckles, and the other side of its outer wall has buckle buttons to drive the left and right base buckles;
sliding plates, which are used to connect the buckle buttons with the left and right base buckles; a base spring, which is used to drive the sliding plates, the buckle buttons, and the left and right base buckles to reset.

Further, the outer walls of the sliding plates are slidably connected inside the base, and the sliding plates are used to drive the buckle buttons and the left and right base buckles to move synchronously.

Further, the two ends of the base spring are respectively arranged inside the upper and lower sliding plates.

Further, the back of the host is provided with host golden fingers, and the base has a base spring contact inside.

Further, the base spring contact is arranged on one side of the host golden finger, and the host golden fingers and the base spring contact are used to provide electrical connection.

Further, the host magnets and the base magnets are arranged in parallel to provide adsorption and auxiliary positioning for the host and the base.

The present disclosure has the following beneficial effects.

Firstly, in the headset, the opening and closing of the left and right base buckles are controlled by the buckle buttons, enabling rapid separation between the host and the base. The left and right base buckles are reset by the spring. When the host inverted buckles are locked, the X - axis and Y - axis directions of the host are fixed, and the stability of the host in the Z-axis direction is also guaranteed. By pressing the buckle buttons and stretching the spring, the left and right base buckles are separated from the host to ensure safe separation between the host and the base. The headset offers high operational convenience and avoids possible issues such as complex disassembly or instability in traditional connection methods.

Secondly, in the headset, the host and the base achieve signal transmission and electrical connection through the contact between the host golden fingers and the base spring contact. Meanwhile, the host magnets and the base magnets attract each other when they get close, ensuring stable positioning of the host and the base when connected. It provides convenient butting operation and effectively avoids external force interference, thus ensuring stable transmission of electrical signals and improving the reliability and stability during use.

### BRIEF DESCRIPTION OF THE DRAWINGS

FIG. 1 is a three-dimensional schematic diagram of a headset proposed by the present disclosure.
FIG. 2 is a schematic diagram of one side of the base of a headset proposed by the present disclosure.
FIG. 3 is a structure diagram of one side of a host of an headset proposed by the present disclosure.
FIG. 4 is an internal schematic diagram of the sliding plate of a headset proposed by the present disclosure.

Reference Signs:
1, Host; 2, Base; 3, Host Magnet; 4, Base Magnet; 5, Host Inverted Buckle; 6, Buckle Button; 7, Left and Right Base Buckles; 8, Host Golden Finger; 9, Base Spring; 10, Sliding Plate; and 11, Base Contact Spring.

### DETAILED DESCRIPTION OF THE EMBODIMENTS

The technical solutions of the embodiments of the present disclosure will be clearly and completely described below with reference to the accompanying drawings. Apparently, the embodiments described below are only a part of the embodiments of the present disclosure, rather than all of them. Based on the embodiments of the present disclosure, all other embodiments obtained by those of ordinary skill in the art without creative efforts shall fall within the protection scope of the present disclosure.

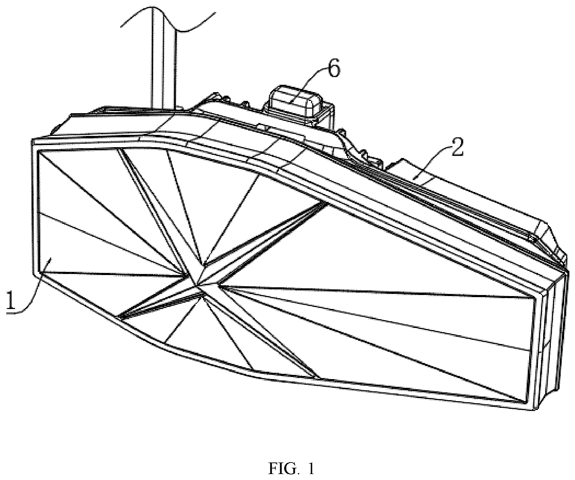

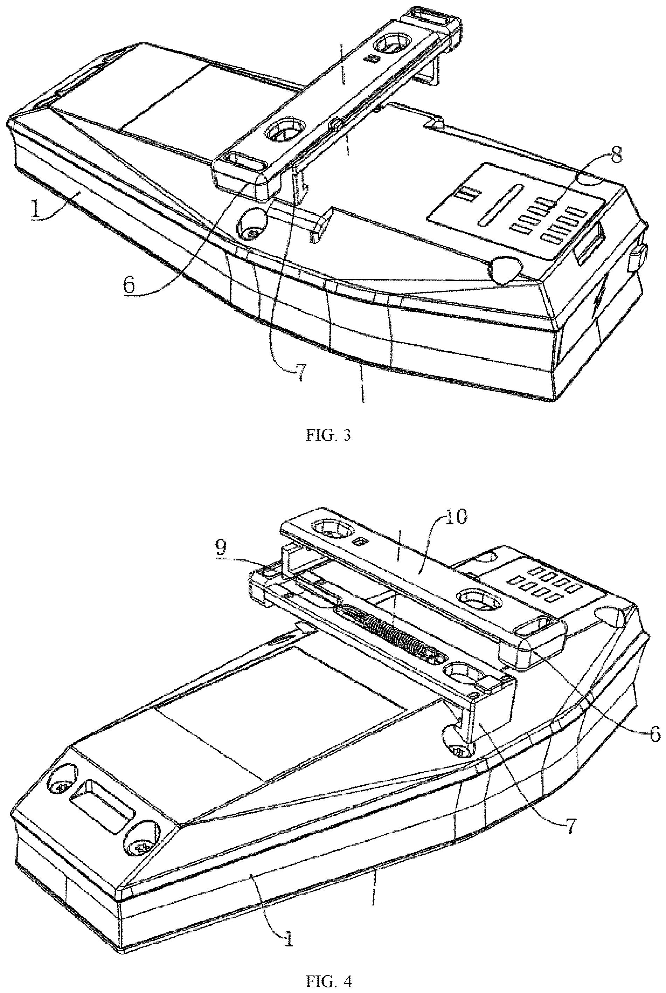

Referring to FIG. 1 to FIG. 4, a headset is provided in an embodiment of the present disclosure. The headset is designed to be installed on a helmet for intercom use, and it includes:
a host 1, which has host magnets 3 at its two inner ends, and one side of its outer wall is equipped with host inverted buckles 5 for assembling and disassembling with the base 2;
a base 2, which has base magnets 4 at its two inner ends, one side of its outer wall has left and right base buckles 7 for buckling with the host inverted buckles 5, and the other side of its outer wall has buckle buttons 6 for driving the left and right base buckles 7;
sliding plates 10, which are used to connect the buckle buttons 6 with the left and right base buckles 7;
a base spring 9, which is used to drive the sliding plates 10, the buckle buttons 6 and the left and right base buckles 7 to reset.

Specifically, the separation process of the host 1 and the base 2 is achieved through the buckle buttons 6. When a user presses the buckle buttons 6, the left and right base buckles 7 will be stretched and opened due to the telescoping action of the base spring 9, causing the left and right base buckles 7 to disengage from the buckling area of the host 1. Meanwhile, the elastic force provided by the base spring 9 enables the left and right base buckles 7 to quickly reset and return to their original positions. Through this action, the host 1 and the base 2 are successfully separated. It is worth noting that the separation between the host 1 and the base 2 is not only convenient but also reliable, preventing possible complex operations or unstable factors in traditional disassembly methods. With this design, the flexible disassembly and assembly of the host and the base can be ensured without compromising the user experience.

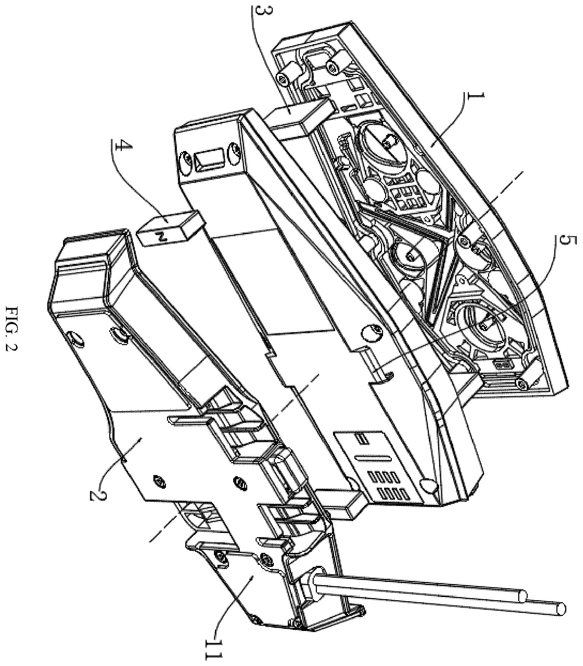

Referring to FIG. 1 and FIG. 2, the host 1 has host magnets 3 inside, and the base 2 has base magnets 4 inside. The outer walls of the sliding plates 10 are slidably connected inside the base 2. The sliding plates 10 are used to drive the buckle buttons 6 and the left and right base buckles 7 to move synchronously. Both ends of the base spring 9 are respectively located inside the upper and lower sliding plates 10. The back of the host 1 is equipped with host golden fingers 8, and the base 2 has a base spring contact 11 inside. The base spring contact 11 is arranged on one side of the host golden finger 8, and the host golden fingers 8 and the base spring contact 11 are used to provide electrical connection. The host magnets 3 and the base magnets 4 are arranged in parallel positions to provide adsorption and auxiliary positioning for the host 1 and the base 2.

Specifically, when connecting the host 1 and the base 2, magnetic adsorption positioning is adopted to assist in fixing and ensure the transmission of electrical signals. When the host 1 is adsorbed to the base 2 by the host magnets 3 attracting the base magnets 4, the stable electrical connection is ensured through the contact between the host golden fingers 8 and the base spring contact 11. At this time, the mutual attraction between the host magnets 3 and the base magnets 4 helps the host 1 to be precisely positioned, and in cooperation with the left and right base buckles 7 and the surrounding limit ribs, it firmly fixes the host 1, preventing any looseness in the X-axis and Y-axis directions. With the help of this structure, not only can the smooth transmission of electrical signals be ensured when the host 1 and the base 2 are connected, but also the signal instability caused by external interference can be avoided, thus greatly improving the reliability and stability of the device during use.

The working principle is as follows. First, the host 1 is connected to the base 2 through the contact between the host golden fingers 8 and the base spring contact 11 to achieve signal transmission. The host magnets 3 and the base magnets 4 attract each other for auxiliary positioning when they are close. When the host 1 is adsorbed to the base 2 by the host magnets 3, the left and right base buckles 7 will be pushed open by the host 1, and then the left and right base buckles 7 will reset by the action of the base spring 9. After resetting, the left and right base buckles 7 enter the host inverted buckles 5 to lock the host 1 in the Z-axis direction. Meanwhile, the limit ribs around the product can fix the movement of the host 1 in the X-axis and Y-axis directions, thus playing a role in fixing the host 1. When the buckle buttons 6 are pressed down to stretch the spring, the left and right base buckles 7 will disengage from the buckling area of the host 1, and the host 1 will be separated from the left and right base buckles 7, thus achieving the separation of the host 1 from the base 2. The opening and closing of the buckle buttons 6 drive the opening and closing of the left and right base buckles 7, and this opening and closing is realized through the telescoping of the base spring 9.

Finally, it should be noted that the above are only preferred embodiments of the present disclosure and are not intended to limit the present disclosure. Although the present disclosure has been described in detail with reference to the above embodiments, those skilled in the art can still make modifications to the technical solutions described in the above embodiments or make equivalent substitutions for some of the technical features. Any modifications, equivalent substitutions, improvements, etc. made within the spirit and principles of the present disclosure shall fall within the protection scope of the present disclosure.

## Claims

1. A headset configured to be installed on a helmet for intercom use, comprising:
a host (1), which has host magnets (3) at its two inner ends, and one side of an outer wall of the host (1) has host inverted buckles (5) for assembly and disassembly with the base (2);
a base (2), which has base magnets (4) at its two inner ends, one side of an outer wall of the base (2) has left and right base buckles (7) for buckling with the host inverted buckles (5), and the other side of an outer wall of the base (2) has buckle buttons (6) for driving the left and right base buckles (7);
sliding plates (10), which are configured to connect the buckle buttons (6) with the left and right base buckles (7); and
a base spring (9), which is configured to drive the sliding plates (10), the buckle buttons (6) and the left and right base buckles (7) to reset.

2. The headset according to claim 1, wherein the host (1) has the host magnets (3) inside and the base (2) has the base magnets (4) inside.

3. The headset according to claim 1, wherein the outer walls of the sliding plates (10) are slidably connected inside the base (2), and the sliding plates (10) are used to drive the buckle buttons (6) and the left and right base buckles (7) to move synchronously.

4. The headset according to claim 1, wherein both ends of the base spring (9) are respectively located inside the upper and lower sliding plates (10).

5. The headset according to claim 1, wherein the back of the host (1) has host golden fingers (8) and the base (2) has a base spring contact (11) inside.

6. The headset according to claim 5, wherein the base spring contact (11) is arranged on one side of the host golden finger (8), and the host golden fingers (8) and the base spring contact (11) are used to provide electrical connection.

7. The headset according to claim 2, wherein the host magnets (3) and the base magnets (4) are arranged in parallel positions and used to provide adsorption and auxiliary positioning for the host (1) and the base (2).
